# EUROPEAN PATENT APPLICATION

(11) **EP 4 472 076 A1**
(43) Date of publication of application: **04.12.2024**
(21) Application number: 23782721.7
(22) Date of filing: 30.05.2023
(51) Int. Cl.: H03K 3/0231

(54) **RC RELAXATION OSCILLATOR WITH VARIABLE CAPACITOR BASED ON VOLTAGE CONTROL AND HAVING TEMPERATURE COMPENSATION FUNCTION**

(30) Priority: 20.04.2023 CN 202310425712
(71) Applicant: Shanghai Guihong Microelectronics Technology Co., Ltd., Shanghai 201815 (CN)
(72) Inventor: LV, Hongbo, Shangahai, 201815 (CN); TIAN, Xuehong, Shangahai, 201815 (CN); LIU, Huibo, Shangahai, 201815 (CN)
(74) Representative: Dai, Simin
(86) International application number: PCT/CN2023/097123
(87) International publication number: WO 2024/216712

(57) **Abstract**

The present disclosure provides a voltage controlled variable capacitor based RC relaxation oscillator with temperature compensation, which includes: a main chip, including: an RC relaxation oscillator, configured to generate a clock signal, and a control circuit, configured to collect a temperature of the main chip, acquire a temperature sampled value, and output an analog voltage according to the temperature sampled value and couple the analog voltage to a first end of the variable capacitor. The present disclosure adopts a voltage control based variable capacitor with temperature compensation, which can improve an accuracy of frequency compensation to 0.1Hz or lower, making it possible to replace quartz crystal oscillators with all-silicon chips, and without the need for expensive MEMS process devices, so as to reduce costs. A temperature drift value and frequency accuracy are improved exponentially by temperature compensation, and the operation is stable. Meanwhile, a variable capacitor structure with temperature compensation of the present disclosure can be applied to any RC relaxation oscillator with high matching, so that mass production can be realized with the premise of ensuring the product yield.

## Description

### TECHNICAL FIELD

The present disclosure relates to the field of electronic circuit technologies, and in particular to, a voltage controlled variable capacitor based RC relaxation oscillator with temperature compensation.

### BACKGROUND

An RC circuit, that is, a resistor-capacitance circuit, refers to a circuit composed of resistors R and capacitors C in an analog circuit and a digital circuit. A traditional RC-based relaxation oscillator is widely used in various clock designs that do not require high accuracy, such as an MCU (Microcontroller Unit), but a temperature drift value of this oscillator is generally about 1000 ppm/°C in the range of -55 °C to 125 °C.

Although a person skilled in the art can improve the temperature drift value to about 10-100 ppm/°C by means of digital circuit trimming and temperature correction, there are still some fundamental defects: first, it is impossible to balance product yield with large-scale stable mass production; second, the temperature drift coefficient is still too high to make it possible to replace a quartz crystal oscillator; and third, it is difficult to effectively provide sufficient initial accuracy of, for example, 100 ppm, because the effect of parasitic resistance/capacitance at high precision cannot be eliminated.

### SUMMARY

In order to solve the above technical problems, the present disclosure provides a voltage controlled variable capacitor based RC relaxation oscillator with temperature compensation. In order to have a basic understanding of some aspects of the disclosed embodiments, a brief summary is given below. This summary is not a general comment, nor is it intended to identify key/important elements or delineate the protection scope of these embodiments. Its sole purpose is to present some concepts in a simple form as a preface to the detailed description that follows.

The present disclosure adopts the following technical solution:
The present disclosure provides a voltage controlled variable capacitor based RC relaxation oscillator with temperature compensation, including:
a main chip, including: an RC relaxation oscillator, configured to generate a clock signal, and the RC relaxation oscillator includes a variable capacitor, a bias current source, a comparator and a resistor; and
a control circuit, configured to collect a temperature of the main chip, acquire a temperature sampled value, and output an analog voltage according to the temperature sampled value and couple the analog value to a first end of the variable capacitor.

Further, the main chip includes at least one-way of the variable capacitor.

Further, the control circuit includes: a temperature sensor; and the temperature sensor is configured to collect the temperature of the main chip and output the temperature sampled value.

Further, the control circuit further includes: a digital signal processor; the digital signal processor is coupled to the variable capacitor and the temperature sensor, and is configured to receive temperature sampled value and perform calculation, so as to obtain and output a voltage of the variable capacitor corresponding to the temperature.

Further, the control circuit further includes: an analog-to-digital converter, the analog-to-digital converter is coupled to the temperature sensor and the digital signal processor, and the analog-to-digital converter receives the temperature sampled value, converts the temperature sampled value into a digital voltage signal and transmits the digital voltage signal to the digital signal processor.

The control circuit further includes: a digital-to-analog converter, the digital-to-analog converter is coupled to the digital signal processor and the first end of the variable capacitor, and the digital-to-analog converter converts the voltage output by the digital signal processor into an analog voltage signal and applies the analog voltage signal to the first end of the variable capacitor.

The control circuit further includes: a voltage control generator, the voltage control generator includes an adder and/or a multiplier; and the voltage control generator processes the temperature sampled value output by the temperature sensor, outputs an analog voltage signal, and applies the analog voltage signal to the first end of the variable capacitor.

Further, a data input end of the digital signal processor is connected with an output end of the main chip, and the digital signal processor further inputs a reference clock signal provided by an external clock source.

Further, the variable capacitor is a metal oxide semiconductor field effect transistor MOSFET capacitor or a Varactor capacitor.

Further, the bias current source outputs two groups of current sources, where an output end of a first group of current sources is coupled to a first end of the resistor, and an output end of a second group of current sources is coupled to a second end of the variable capacitor; the first end of the resistor is further coupled to a first input end of the comparator, and a second end of the resistor is grounded, to generate a reference voltage at the first input end of the comparator; and a second input end of the comparator is coupled to the second end of the variable capacitor.

Further, the main chip further includes: a logic controller, and the logic controller is connected with an output end of the comparator.

The beneficial effects brought by the present disclosure are as follows:
1. The present disclosure adopts a voltage control based variable capacitor with temperature compensation, which can improve an accuracy of frequency compensation to 0.1Hz or lower, making it possible to replace quartz crystal oscillators with all-silicon chips, and without the need for expensive MEMS (Micro-Electro-Mechanical System) process devices, so as to reduce costs.
2. A temperature drift value and frequency accuracy are improved exponentially by temperature compensation, and the operation is stable. Meanwhile, a variable capacitor structure with temperature compensation of the present disclosure can be applied to any RC relaxation oscillator with high matching, so that mass production can be realized with the premise of ensuring the product yield.

### BRIEF DESCRIPTION OF DRAWINGS

In order to explain the embodiments of the present disclosure or the technical solution in the prior art more clearly, accompanying drawings needed to be used in the description of the embodiments or the prior art will be briefly introduced below. Obviously, the accompanying drawings in the following description are only some embodiments of the present disclosure, and other accompanying drawings can be acquired according to these accompanying drawings without creative work for ordinary people in the field.
FIG. 1 is a schematic structural diagram of an RC relaxation oscillator in an embodiment of the present disclosure.
FIG. 2 is a schematic structural diagram of an RC relaxation oscillator with two-way variable capacitors of the present disclosure.
FIG. 3 is a schematic structural diagram of an RC relaxation oscillator with two-way variable capacitors of the present disclosure.
FIG. 4 is a schematic structural diagram of an RC relaxation oscillator with two-way variable capacitors combined with non-variable capacitors of the present disclosure.

### DETAILED DESCRIPTION

Embodiments of the present disclosure will be described in detail with reference to the accompany drawings. It should be clear that the described embodiments are only a part of the embodiments of the present disclosure, but not the whole embodiments. Based on the embodiments in the present disclosure, all other embodiments obtained by ordinary people in the field without creative work belong to the scope of protection in the present disclosure.

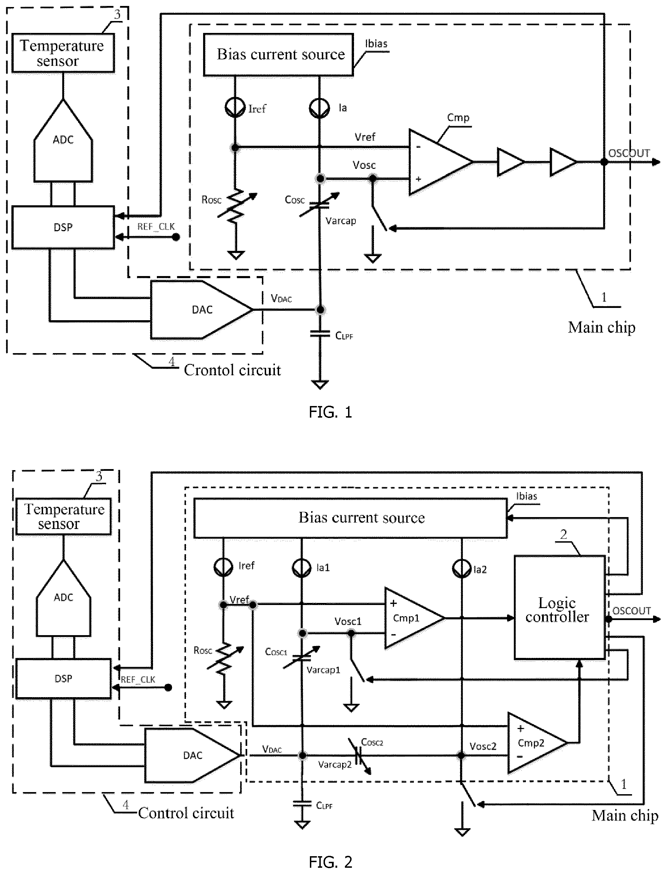

As shown in FIGS. 1-4, in some illustrative embodiments, the present disclosure provides a voltage controlled variable capacitor (VCVC) based RC relaxation oscillator with temperature compensation, which includes: a main chip 1 and a control circuit4. The main chip 1 includes a circuit for realizing an oscillator and generating a clock signal, and the control circuit 4 is configured to control the main chip 1 by using a temperature compensation algorithm, so as to compensate for a drift caused by an influence of temperature change on a frequency of the clock signal.

As shown in FIG. 1, the main chip 1 is configured to generate the clock signal, which includes: a bias current source Ibias, a comparator Cmp, a resistor Rose, and a variable capacitor Cosc. The variable capacitor Cosc is a MOSFET (metal-oxide-semiconductor field-effect transistor) capacitor, a Varactor capacitor or a variable capacitor that can be controlled by voltage under any process conditions, thus providing more possibilities for the selection of production process.

**For** example, the main chip 1 uses at least one way (branch) of the variable capacitor. As shown in FIGS. 2-4, they are structural diagrams of the RC relaxation oscillator when two-way variable capacitors are used. At this time, the two-way variable capacitors are respectively referred to as a first variable capacitor Cosc1 and a second variable capacitor Cosc2, and corresponding comparators are respectively referred to as a first comparator Cmp1 and a second comparator Cmp2. An introduction of two-way or multi-way voltage controlled variable capacitors can realize more functions and more accurate multi-dimensional RC relaxation oscillator application scenarios, and the two-way or multi-way voltage controlled variable capacitor structure can be completely controlled independently, and can also be controlled in various combinations according to actual use requirements.

For example, as shown in FIG. 1, the bias current source Ibias outputs two groups of current sources, which are respectively referred to as a first current source Iref and a second current source Ia. The first current source Iref generates a reference voltage Vref of the comparator Cmp at both ends of the resistor Rose. The second current source Ia charges the variable capacitor Cosc.

For example, as shown in FIGS. 2-4, when two-way variable capacitors are used, the second current source Ia is further divided into a current source Ia1 and a current source Ia2 to charge the variable capacitor of each way.

For example, the main chip 1 can further include: a logic controller 2, which is connected with output ends of the first comparator Cmp1 and the second comparator Cmp2, and by using the logic controller 2, comparator delay and an impact caused by offset of current, capacitance and comparator input in the RC relaxation oscillator can be reduced.

The control circuit 4 included in the VCVC based RC relaxation oscillator is configured to collect a temperature of the main chip 1, acquire a temperature sampled value, and output an analog voltage signal V_{DAC} according to the temperature sampled value, and apply the analog voltage signal V_{DAC} to the variable capacitor Cosc.

In some examples, the control circuit 4 may include a temperature sensor 3, a digital signal processor (DSP), an analog-to-digital Converter (ADC), and a digital-to-analog Converter (DAC).

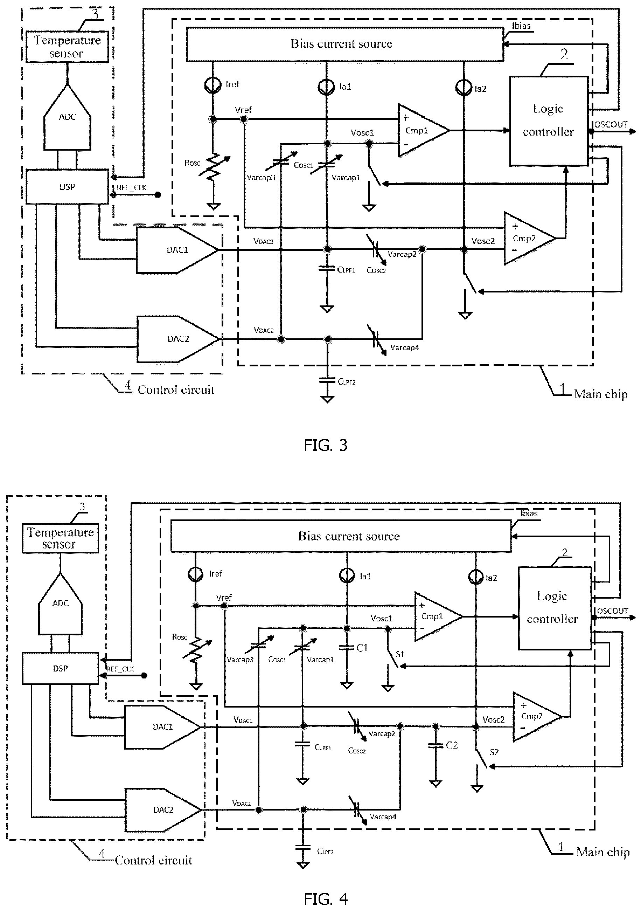

For example, as shown in FIGS. 3 and 4, for the case of two-way variable capacitors, two digital-to-analog converters, namely, a first digital-to-analog converter DAC1 and a second digital-to-analog converter DAC2, can be provided to generate a first analog voltage signal V_{DAC1} and a second analog voltage signal V_{DAC2} respectively.

The temperature sensor 3 is configured to collect the temperature of the main chip 1 and directly transmit the temperature sampled value to the DSP. In some examples, the temperature sampled value may be a digital value. The DSP can acquire the temperature sampled value collected by the temperature sensor 3 and calculate it by using a temperature compensation algorithm, and get a voltage digital value that needs to control the variable capacitor, such as a binary value.

Further, in some examples, the temperature sensor 3 samples the temperature of the main chip 1, and the temperature sampled value can be an analog value. It is converted into a digital voltage signal through the ADC, and is uploaded to the DSP. The DAC converts a voltage digital value output by the DSP into an analog voltage signal and applies it to the variable capacitor Cosc. A data input end of the DSP is connected with an output end of the main chip 1, and a reference clock signal REF_CLK provided by an external clock source is acquired at the same time.

In this embodiment, the RC relaxation oscillator uses the temperature sensor 3 to sample the temperature of the main chip 1, and then converts it into a digital value through the ADC. The DSP calculates a voltage digital value of the variable capacitor Cosc corresponding to a current temperature according to a specific temperature compensation algorithm, where any existing compensation algorithm can be selected for the temperature compensation algorithm, which will not be described in detail herein. The DAC applies the analog voltage signal V_{DAC} required for frequency stability to the variable capacitor Cosc to obtain a corresponding capacitance value at the current temperature, so as to compensate a drift formed by temperature change on the frequency. Based on this method, a frequency of an output end OSCOUT of the RC relaxation oscillator can reach an initial accuracy of 10 ppm, and a frequency temperature drift of the output end OSCOUT of the RC relaxation oscillator can be less than 100 ppm in the range of -55 °C to 125 °C, such as about 0.1-1 ppm/°C.

The analog voltage signal V_{DAC} for controlling the variable capacitor Cosc is not limited to various precision DACs. In one example, the ADC, the DSP and the DAC can be replaced by a voltage control generator, which can include an adder, a multiplier and other forms of voltage control generators. The temperature sampled value output by the temperature sensor 3 is processed by the voltage control generator to output the analog voltage signal V_{DAC}, which is applied to the variable capacitor Cosc. That is, according to the temperature compensation requirements, the temperature sampled value generated by temperature sensor 3 is used to generate an analog voltage signal V_{DAC} through various adders and multipliers, expanding the scenario of using the voltage controlled variable capacitor based RC relaxation oscillator with temperature compensation.

The voltage controlled variable capacitor with temperature compensation disclosed herein can improve an accuracy of frequency compensation to 0.1 Hz or lower, making it possible to replace quartz crystal oscillators with all-silicon chips, and without the need for expensive MEMS process devices. At the same time, any RC relaxation oscillator can reference a voltage controlled variable capacitor architecture to achieve exponential improvements in temperature drift and frequency accuracy. Moreover, according to any temperature compensation algorithm, the DSP can be combined with a voltage controlled variable capacitor based RC relaxation oscillator with temperature compensation to achieve better temperature compensation function.

As shown in FIG. 4, a logic control and circuit architecture of reducing a delay of comparator and an offset of RC relaxation oscillator is shown. Multi-way voltage controlled variable capacitors, along with non-variable capacitors C1, C2 or capacitor arrays are introduced to achieve more functions and more accurate multi-dimensional RC relaxation oscillator usage scenarios. Moreover, the multi-way voltage controlled variable capacitors and non-variable capacitors and capacitor arrays can be controlled completely independently, and can also be controlled in various combinations as needed. At this time, the voltage control generator can be either a digital-to-analog converter or other forms of voltage control generators such as a multiplier and an adder.

The above is only a specific implementation of the present disclosure, but the protection scope of the present disclosure is not limited to this. Any variation or substitution readily conceivable by any person skilled in the art within the technical scope disclosed in the present disclosure should be included in the protection scope of the present disclosure. Therefore, the protection scope of the present disclosure should be based on the protection scope of the claims.

## Claims

1. A voltage controlled variable capacitor based resistor-capacitance RC relaxation oscillator with temperature compensation, comprising:
a main chip, comprising: an RC relaxation oscillator, configured to generate a clock signal, and the RC relaxation oscillator comprises a variable capacitor, a bias current source, a comparator and a resistor; and
a control circuit, configured to collect a temperature of the main chip, acquire a temperature sampled value, and output an analog voltage according to the temperature sampled value and couple the analog voltage to a first end of the variable capacitor.

2. The voltage controlled variable capacitor based RC relaxation oscillator with temperature compensation according to claim 1, wherein the main chip comprises at least one-way of the variable capacitor.

3. The voltage controlled variable capacitor based RC relaxation oscillator with temperature compensation according to claim 1 or 2, wherein the control circuit comprises: a temperature sensor; and
the temperature sensor is configured to collect the temperature of the main chip and output the temperature sampled value.

4. The voltage controlled variable capacitor based RC relaxation oscillator with temperature compensation according to claim 3, wherein the control circuit further comprises: a digital signal processor;
the digital signal processor is coupled to the variable capacitor and the temperature sensor, and is configured to receive the temperature sampled value and perform calculation, so as to obtain and output a voltage of the variable capacitor corresponding to the temperature.

5. The voltage controlled variable capacitor based RC relaxation oscillator with temperature compensation according to claim 4, wherein the control circuit further comprises: an analog-to-digital converter, the analog-to-digital converter is coupled to the temperature sensor and the digital signal processor, and the analog-to-digital converter receives the temperature sampled value, converts the temperature sampled value into a digital voltage signal and transmits the digital voltage signal to the digital signal processor.

6. The voltage controlled variable capacitor based RC relaxation oscillator with temperature compensation according to claim 4 or 5, wherein the control circuit further comprises: a digital-to-analog converter, the digital-to-analog converter is coupled to the digital signal processor and the first end of the variable capacitor, and the digital-to-analog converter converts the voltage output by the digital signal processor into an analog voltage signal and applies the analog voltage signal to the first end of the variable capacitor.

7. The voltage controlled variable capacitor based RC relaxation oscillator with temperature compensation according to claim 3, wherein the control circuit further comprises: a voltage control generator, the voltage control generator comprises an adder and/or a multiplier; and the voltage control generator processes the temperature sampled value output by the temperature sensor, outputs an analog voltage signal, and applies the analog voltage signal to the first end of the variable capacitor.

8. The voltage controlled variable capacitor based RC relaxation oscillator with temperature compensation according to any one of claims 4 to 6, wherein a data input end of the digital signal processor is connected with an output end of the main chip, and the digital signal processor further inputs a reference clock signal provided by an external clock source.

9. The voltage controlled variable capacitor based RC relaxation oscillator with temperature compensation according to any one of claims 1 to 8, wherein the variable capacitor is a metal oxide semiconductor field effect transistor MOSFET capacitor or a Varactor capacitor.

10. The voltage controlled variable capacitor based RC relaxation oscillator with temperature compensation according to any one of claims 1 to 9, wherein,
the bias current source outputs two groups of current sources, wherein an output end of a first group of current sources is coupled to a first end of the resistor, and an output end of a second group of current sources is coupled to a second end of the variable capacitor;
the first end of the resistor is further coupled to a first input end of the comparator, and a second end of the resistor is grounded to generate a reference voltage at the first input end of the comparator; and
a second input end of the comparator is coupled to the second end of the variable capacitor.

11. The voltage controlled variable capacitor based RC relaxation oscillator with temperature compensation according to claim 10, wherein the main chip further comprises: a logic controller, and the logic controller is connected with an output end of the comparator.
